# EUROPÄISCHE PATENTSCHRIFT

(11) **EP 3 613 071 B1**
(45) Veröffentlichungstag und Bekanntmachung des Hinweises auf die Patenterteilung: **06.04.2022**
(21) Anmeldenummer: 18716617.8
(22) Anmeldetag: 10.04.2018
(51) Int. Cl.: H01L 21/677, H01L 21/68, H01L 21/67, H01L 21/687, H01L 21/673, B66F 9/18, B25J 9/04, B25J 15/00, B25J 5/00, B25J 19/02, B66F 9/06, B66F 9/065

(54) **ROBOTERGREIFER ZUM HANDHABEN VON OBJEKTEN, INSBESONDERE BEHÄLTERN**
ROBOT GRIPPER FOR HANDLING OBJECTS, IN PARTICULAR CONTAINERS
DISPOSITIF DE SAISIE ROBOTIC POUR MANIPULER DES OBJETS, EN PARTICULIER DES RECIPIENTS

(30) Priorität: 20.04.2017 DE 102017206652
(43) Veröffentlichungstag der Anmeldung: 26.02.2020
(73) Patentinhaber: KUKA Deutschland GmbH, 86165 Augsburg (DE)
(72) Erfinder: GLATZ, Hans, 86179 Augsburg (DE); SCHUKOW, Eugen, 86156 Augsburg (DE); AKBAS, Adil, 86179 Augsburg (DE)
(74) Vertreter: Oelke, Jochen
(86) Internationale Anmeldenummer: PCT/EP2018/059137
(87) Internationale Veröffentlichungsnummer: WO 2018/192799

(56) Entgegenhaltungen:
- FR-A1- 2 826 897
- US-A1- 2011 005 966
- US-A1- 2011 245 964
- US-A1- 2015 063 963
- US-A1- 2015 235 883
- US-A1- 2015 255 318
- US-A1- 2015 287 623
- US-B1- 6 468 021

## Beschreibung

Die Erfindung betrifft einen Robotergreifer zum Handhaben von jeweils wenigstens einen Haltefuß aufweisenden Objekten, insbesondere Behältern, Ventilen oder jeglichen Objekten aufweisend einen Flansch mittels eines Roboters, aufweisend einen Greifergrundkörper, der einen Anschlussflansch aufweist, der zur Befestigung des Robotergreifers an einem Werkzeugflansch eines Roboterarms ausgebildet ist. Die Erfindung betrifft außerdem ein zugehöriges Verfahren.

Aus FR2826897-A1 ist eine Robotervorrichtung mit Greifer zur Handhabung von Reinraumbehältern bekannt (siehe Abb. 3, 4, 14-19 und 22 in diesem Dokument).

Aus der DE 20 2010 007 169 U1 ist eine Vorrichtung zum Handhaben und/oder Transportieren von Behältern, insbesondere von fass- oder kegelartigen Behältern bekannt, mit einem an einem Roboter oder einem Handling-Gerät vorgesehenen Greifer für diese Behälter.

Aus der US 2009/0297299 A1 sind Reinraum-Behälter bekannt, die zum Transport insbesondere von dünnen Scheiben aus Halbleitermaterial, auf die integrierte Schaltungen aufgebaut werden, d.h. von Wafern ausgebildet sind. Solche Reinraum-Behälter werden in Fachkreisen auch als FOUP (engl.: Front Opening Unified Pod / Front Opening Universal Pod) bezeichnet. Derartige Reinraum-Behälter weisen ein Behältergehäuse auf, das an seiner Außenwand wenigstens einen Haltefuß aufweist, derart, dass die Reinraum-Behälter automatisiert gehandhabt werden können.

Die US 2011/245964 A1 zeigt ein selbstausrichtendes automatisiertes Materialhandhabungssystem.

Aus der US2015/235883 A1 ist eine Transporteinrichtung für Halbleiterwafer bekannt.

Aufgabe der Erfindung ist es, einen Robotergreifer und ein zugehöriges Verfahren zu schaffen, womit wenigstens einen Haltefuß aufweisende Objekte, insbesondere Behälter, Ventile oder jegliche Objekte aufweisend einen Flansch mittels eines Roboters auf einfache und zuverlässige Weise automatisiert gehandhabt werden können.

Diese Aufgabe wird erfindungsgemäß gelöst durch einen Robotergreifer zum Handhaben von jeweils wenigstens einen Haltefuß aufweisenden Objekten, insbesondere Behältern, Ventilen oder jeglichen Objekten aufweisend einen Flansch mittels eines Roboters, aufweisend einen Greifergrundkörper, der einen Anschlussflansch aufweist, der zur Befestigung des Robotergreifers an einem Werkzeugflansch eines Roboterarms ausgebildet ist, des Weiteren aufweisend einen mit dem Greifergrundkörper verbundenen Gegenhalter, der einen Ausschnitt aufweist, welcher in seiner Form und Größe an den Haltefuß des Objekts angepasst ist, um diesen formschlüssig aufnehmen zu können, und ein am Greifergrundkörper angeordnetes, bevorzugt verstellbar gelagertes, Stellglied, welches ausgebildet ist, in einer Spannstellung gegen den Haltefuß des Objekts zu drücken, um diesen gegen den Gegenhalter zu fixieren und in einer Freigabestellung den Haltefuß freizugeben, derart, dass der Gegenhalter relativ zum Haltefuß verstellbar ist, um den Haltefuß des Objekts von dem Robotergreifer lösen zu können, wobei der Ausschnitt des Gegenhalters als eine umfangsrandgeschlossener Fensterausschnitt ausgebildet ist, wobei die Innenkontur des Fensterausschnitts einer Außenkontur eines Kopfabschnitts des Haltefußes des Objekts zumindest im Wesentlichen entspricht und die Außenkontur des Kopfabschnitts des Haltefußes eine Konturgestalt aufweist, welche wenigstens einen Vorsprung bildet, der in einer Verriegelungsstellung des Robotergreifers wenigstens eine Rastnische des Gegenhalters hintergreift dadurch gekennzeichnet, dass der Gegenhalter eine dem Greifergrundkörper zugewandte Innenwand aufweist, die wenigstens eine Rastnische für den Kopfabschnitt des Haltefußes des Objekts oder des wenigstens einen Vorsprungs des Kopfabschnitts des Haltefußes des Objekts bildet.

Mittels des Gegenhalters und dem Stellglied wird der Haltefuß bzw. ein Kopfabschnitt des Haltefußes des Objekts formschlüssig gehalten, insbesondere eingespannt. Das Stellglied bildet insoweit ein Druckstück, welches den Haltefuß bzw. den Kopfabschnitt des Haltefußes gegen eine Innenwand des Gegenhalters drückt oder presst. Das Stellglied kann insbesondere ein passives Stellglied sein, d.h. es ist nicht aktiv angetrieben ausgebildet, sondern ist nur passiv verstellbar, bspw. durch eine Bewegung des Roboterarms, der den Robotergreifer gegen das Objekt drückt. Die Verstellbarkeit des Gegenhalters bezüglich des Haltefußes kann insbesondere durch eine Drehbewegung gegeben sein. Die Drehbewegung kann insbesondere allein durch eine Bewegung des Roboterarms ausgeführt werden. Insoweit kann der Robotergreifer insgesamt antriebslos d.h. rein passiv ausgebildet sein. Die Drehbewegung des Roboterarms kann in er einfachsten Ausgestaltung eine Drehung des Werkzeugflansches des Roboterarms sein, der durch einen Gelenksmotor des Roboterarms angetrieben wird. Der Haltefuß des Objekts kann einen gegenüber einem Kopfabschnitt des Haltefußes umfangsverringerten Tragabschnitt aufweisen, der den Kopfabschnitt mit einer Objektwand, insbesondere Behälterwand des Objekts, insbesondere Behälters verbindet. Der Kopfabschnitt ist insoweit gegenüber dem Tragabschnitt umfangserweitert ausgebildet, so dass der Haltefuß eine Hinterschneidung bildet, in die der Gegenhalter formschlüssig eingreifen kann.

Der Ausschnitt des Gegenhalters ist als eine umfangsrandgeschlossener Fensterausschnitt ausgebildet, wobei die Innenkontur des Fensterausschnitts einer Außenkontur eines Kopfabschnitts des Haltefußes des Objekts zumindest im Wesentlichen entspricht und die Außenkontur des Kopfabschnitts des Haltefußes eine Konturgestalt aufweist, welche wenigstens einen Vorsprung bildet, der in einer Verriegelungsstellung des Robotergreifers wenigstens eine Rastnische des Gegenhalters hintergreift.

Der Gegenhalter kann in einem Abstand von dem Greifergrundkörper am Robotergreifer befestigt sein, derart, dass zwischen dem Gegenhalter und dem Greifergrundkörper ein Freiraum gebildet wird, der ausgebildet ist, zum Drehen des Robotergreifers relativ zum Haltefuß des Objekts, wenn der Kopfabschnitt des Haltefußes über den Ausschnitt des Gegenhalters hinweg in den Freiraum des Robotergreifers eingetaucht ist.

Der Gegenhalter weist eine dem Greifergrundkörper zugewandte Innenwand auf, die wenigstens eine Rastnische für den Kopfabschnitt des Haltefußes des Objekts oder des wenigstens einen Vorsprungs des Kopfabschnitts des Haltefußes des Objekts bildet.

Das Stellglied kann ein im Zentrum des Robotergreifers axial angeordneter, bevorzugt verstellbar gelagerter, Druckstempel sein, der einen Stempelkopf aufweist, der zum Drücken gegen einen korrespondierenden Sitz am Kopfabschnitt des Haltefußes des Objekts ausgebildet ist. Der Stempelkopf kann zu einer Fein-Positionierung des Robotergreifers am Haltefuß dienen. Das Stellglied kann dazu eine konische Spitze aufweisen, welche an eine korrespondierende konische Oberfläche des Haltefußes angepasst ist. Der Roboter kann dabei eine Drehmomentsensorik aufweisen, um das Stellglied als eine Zentrierspitze verwenden zu können. Diese Zentrierspitze kann der Roboter nutzen, um an der konischen Bohrung des Haltefußes fein zu positionieren. Dies ist besonders dann sinnvoll, wenn beispielsweise aufgrund von Toleranzen eine Abweichung zu beispielhaften Kamera-Daten besteht.

Das Stellglied kann mittels einer Federvorrichtung federvorgespannt am Greifergrundkörper gelagert sein, derart, dass durch die Federvorrichtung eine Federkraft erzeugt wird, welche das Stellglied in seiner Spannstellung selbsttätig gegen den Kopfabschnitt des Haltefußes des Objekts drückt.

Der Haltefuß kann jegliches abstehende Element eines Objekts, bevorzugt ein Flansch sein, das weiterhin bevorzugt hinter- oder untergriffen werden kann.

Der Robotergreifer kann in allen Ausführungen eine Sicherungsvorrichtung aufweisen, die ausgebildet ist, das Stellglied in seiner Spannstellung automatisch zu arretieren. Die Sicherungsvorrichtung verhindert ein ungewolltes Bewegen des Stellglieds, insbesondere ein ungewolltes Lösen des Stellglieds von dem Haltefuß des Objekts, wenn das Stellglied beispielsweise gegen die Federkraft der Federvorrichtung weggedrückt würde. Die Sicherungsvorrichtung kann beispielsweise einen Hubmagneten aufweisen, der einen Sicherungsstift oder eine Sicherungsklinke betätigt. Die Sicherungsvorrichtung bildet insoweit eine mechanische Verriegelung.

Der Robotergreifer kann einen Zentrierstift aufweisen, der an seinem freien Stirnende einen Zentrierkonus aufweist, und/oder der eine Führung bildet, an der das Stellglied axial verstellbar geführt ist. Des Weiteren kann bevorzugt auch das Stellglied an seinem freien Stirnende einen Zentrierkonus aufweisen.

Der Robotergreifer kann in allen Ausführungen wenigstens einen Sensor aufweisen, der ausgebildet ist, die relative Stellung des Robotergreifers bezüglich des Objekts n wenigstens einer Messgröße zu erfassen. Der Sensor kann ein Abstandssensor sein. Der Sensor kann ein optischer Sensor, wie beispielsweise eine Kamera sein. Der Sensor kann eine von dem Roboterarm ausgeführte, mittels der Robotersteuerung programmgesteuerte Annäherung des Robotergreifers an das Objekts und/oder das Ankoppeln/Einfädeln des Robotergreifers an den Haltefuß des Objekts unterstützen bzw. vereinfachen, insbesondere automatisiert ermöglichen. Beispielsweise kann das Objekts eine Markierung oder Kennzeichnung, wie beispielsweise ein 2D-Code, insbesondere ein Barcode, Matrix-Code oder eine QR-Code aufweisen, der von dem optischen Sensor, insbesondere der Kamera erfasst und ausgewertet wird, um die Annäherung zu regeln.

In einer ersten Ausführungsform kann der Sensor als eine Kamera ausgebildet sein, die mit ihrer optischen Achse parallel zu einer seitlichen Längskante des Objekts verlaufend ausgerichtet ist. So kann der neben einem gegriffenen Objekt befindliche Raum auf einfach Weise optisch überwacht werden.

In einer zweiten Ausführungsform kann der Sensor als eine Kamera ausgebildet sein, die mit ihrer optischen Achse quer zu einer seitlichen Längskante des Objekts verlaufend ausgerichtet ist, wobei der Robotergreifer wenigstens einen Umlenkspiegel umfasst, der ausgebildet ist, zum Umlenken von Licht aus einer parallel zu einer seitlichen Längskante des Objekts verlaufenden Richtung in die quer zu der seitlichen Längskante des Objekts verlaufenden Richtung, in der sich die optische Achse der Kamera erstreckt. Durch eine quer zu der seitlichen Längskante des Objekts verlaufenden Ausrichtung des Sensors bzw. der Kamera mit ihrer optischen Achse, wird ein kompakter Aufbau des Robotergreifers erzielt. Mittels des vorzugsweise gegenüber dem Sensor kleineren und leichteren Umlenkspiegels kann weiterhin der neben einem gegriffenen Objekt befindliche Raum auf einfach Weise optisch überwacht werden.

Generell kann der Robotergreifer einen zweiten Sensor aufweisen, der ausgebildet und derart angeordnet ist, dass er einen seitlich eines durch den Robotergreifer gegriffenen Objekts vorhandenen Raum auf Hindernisse überwacht. Mittels des zweiten Sensors, der auch als eine Kamera ausgebildet sein kann, kann ein gewünschter Ablageplatz für das Objekt überprüft, d.h. das Vorhandensein eines freien Platzes zur Ablage des Objekts erkannt werden.

Alternativ oder ergänzend kann der Robotergreifer einen dritten Sensor aufweisen, der ausgebildet und derart angeordnet ist, dass er das Vorhandensein des Objekts, insbesondere des Haltefußes des Objekts am Gegenhalter des Robotergreifers, überwacht. Dazu kann der dritte Sensor beispielsweise an einem Gegenhalter des Robotergreifers angeordnet sein und nach innen ausgerichtet sein, so dass mittels des dritten Sensors das Vorhandensein eines Kopfabschnitts eines Haltefußes des Behälters und/oder das Vorhandensein eines zwischen dem Behälter und dem Haltefuß ausgebildeten Verbindungsschaftes innerhalb des Gegenhalters festgestellt werden kann. Mittels des dritten Sensors kann ein ordnungsgemäßes Ergreifen des Objekts durch den Robotergreifer und/oder ein ordnungsgemäßes Lösen des Objekts von dem Robotergreifer festgestellt werden.

Der Behälter kann ein Reinraum-Behälter sein. Der Reinraum-Behälter kann als ein sogenannter FOUP ausgebildet sein. Der Reinraum-Behälter kann insbesondere gemäß US 2009/0297299 A1 oder in analoger bzw. ähnlicher Weise ausgebildet sein.

Die Aufgabe wird außerdem gelöst durch ein Verfahren zum Handhaben von jeweils wenigstens einen Haltefuß aufweisenden Objekten, insbesondere Behältern mittels eines Roboters, aufweisend die Schritte:
- Heranführen eines Robotergreifers an einen Haltefuß eines aufzunehmenden Objekts durch Bewegen eines Roboterarms des Roboters, automatisch angesteuert durch eine Robotersteuerung des Roboterarms, die ausgebildet ist, die Glieder des Roboterarms durch Verstellen der die Glieder des Roboterarms verbindenden Gelenke des Roboterarms automatisch zu bewegen, bis ein Ausschnitt eines Gegenhalters des Robotergreifers mit dem Haltefuß fluchtet,
- Drücken des Robotergreifers gegen den Haltefuß des Objekts derart, dass ein verstellbares Stellglied (12) des Robotergreifers (4) gegen den Haltefuß (6) des Objekts (5) gedrückt wird, durch das Drücken verstellt wird und in Folge dessen eine Vorspannung zwischen Stellglied (12) und Gegenhalters (10) erzeugt wird, und dabei ein Kopfabschnitt des Haltefußes durch den Ausschnitt des Gegenhalters hindurch in einen Freiraum des Robotergreifers eindringt,
- Drehen des Robotergreifers relativ zum Haltefuß des Objekts durch Bewegen des Roboterarms, automatisch angesteuert durch die Robotersteuerung, die ausgebildet ist, die Glieder des Roboterarms durch Verstellen der die Glieder des Roboterarms verbindenden Gelenke des Roboterarms automatisch zu bewegen, bis wenigstens ein Vorsprung des Kopfabschnitts des Haltefußes den Ausschnitt des Gegenhalters hintergreift und in wenigstens einer Rastnische des Gegenhalters einschwenkt,
- Fixieren des Objekts bezüglich des Robotergreifers in einer Anordnung, in welcher der wenigstens eine Vorsprung des Kopfabschnitts des Haltefußes den Ausschnitt des Gegenhalters hintergreift und in die wenigstens eine Rastnische des Gegenhalters eingeschwenkt ist, durch ein zum Drücken entgegengesetztes Bewegen des Robotergreifers (4), sodass eine verbleibende Vorspannung des Stellglieds (12) den Haltefuß (6) zwischen dem Stellglied (12) und dem Gegenhalter (10) verspannt.

Bei dem Verfahren kann vorgesehen sein, dass in der Anordnung, in welcher der wenigstens eine Vorsprung des Kopfabschnitts des Haltefußes den Ausschnitt des Gegenhalters hintergreift und in die wenigstens eine Rastnische des Gegenhalters eingeschwenkt ist, und durch Drücken des verstellbaren Stellglieds des Robotergreifers gegen den Haltefuß des Objekts das Objekt bezüglich des Robotergreifers fixiert ist, das Stellglied mittels einer Sicherungsvorrichtung automatisch arretiert wird.

Das Heranführen des Robotergreifers an den Haltefuß des aufzunehmenden Objekts kann durch Bewegen des Roboterarms des Roboters, automatisch angesteuert durch die Robotersteuerung, die ausgebildet ist, die Glieder des Roboterarms durch Verstellen der die Glieder des Roboterarms verbindenden Gelenke des Roboterarms automatisch zu bewegen, bis ein Ausschnitt des Gegenhalters mit dem Haltefuß fluchtet, kann dadurch unterstützt werden, dass ein am Robotergreifer befestigter Zentrierstift in einem durch die Robotersteuerung kraft-/momentregelten Betrieb des Roboterarms in einer den Kopfabschnitt des Haltefußes des Objekts berührenden Weise an das Objekt herangeführt wird, bis der Ausschnitt des Gegenhalters mit dem Kopfabschnitt des Haltefußes des Objekts fluchtet.

Das Heranführen des Robotergreifers an den Haltefuß des aufzunehmenden Objekts durch Bewegen des Roboterarms des Roboters, automatisch angesteuert durch die Robotersteuerung, die ausgebildet ist, die Glieder des Roboterarms durch Verstellen der die Glieder des Roboterarms verbindenden Gelenke des Roboterarms automatisch zu bewegen, bis ein Ausschnitt des Gegenhalters mit dem Haltefuß fluchtet, kann durch wenigstens einen an dem Robotergreifer angeordneten Sensor unterstützt werden, der wenigstens eine Messgröße einer relativen Stellung des Robotergreifers bezüglich des Objekts erfasst und zur automatischen Ansteuerung des Roboterarms mittels der Robotersteuerung auf Grundlage der wenigstens einen erfassten Messgröße an die Robotersteuerung übermittelt.

Erfindungsgemäß kann vorgesehen sein, dass das Verfahren mittels eines Roboters durchgeführt wird, dessen Werkzeugflansch einen Robotergreifer nach einem oder mehreren der beschriebenen Ausführungsformen trägt.

Ein konkretes Ausführungsbeispiel der Erfindung ist in der nachfolgenden Figurenbeschreibung unter Bezugnahme auf die beigefügten Figuren näher erläutert.

Es zeigen:
- Fig. 1: eine perspektivische Darstellung einer beispielhaften Handhabungssituation, bei der ein auf einem fahrerlosen Transportfahrzeug angeordneter Roboter einen Werkzeugflansch aufweist, an dem ein erfindungsgemäßer Robotergreifer befestigt ist, der ein beispielhaftes Objekt, insbesondere einen beispielhaften Behälter greift,
- Fig. 2a bis 2c: drei Ansichten eines beispielhaften Behälters in einer Ausführungsform in Art eines FOUP-Behälters,
- Fig. 3: eine perspektivische Darstellung eines Ausschnitts eines Roboterarms zusammen mit einer Ausführungsvariante eines erfindungsgemäßen Robotergreifers und einem FOUP-Behälter gemäß Fig. 2a bis 2c,
- Fig. 4: einen Schnittdarstellung durch den Robotergreifer in einer an einen Haltefuß eines aufzunehmenden Behälters herangeführten Position,
- Fig. 5: einen Schnittdarstellung durch den Robotergreifer in einer mit dem Haltefuß des aufzunehmenden Behälters verrasteten Position,
- Fig. 6a: eine Momentaufnahme einer Situation, in welcher der Robotergreifer mit dem Haltefuß des Behälters fluchtet,
- Fig. 6b: eine Momentaufnahme einer Situation, in welcher der Haltefuß des Behälters in den Ausschnitt des Robotergreifers eindringt,
- Fig. 7a: eine Momentaufnahme einer Situation, in welcher der Haltefuß des Behälters in einem Freiraum des Robotergreifer positioniert ist, in einer Entriegelungsstellung, zum Drehen des Robotergreifers relativ zum Haltefuß des Behälters,
- Fig. 7b und 8a: eine Momentaufnahme einer Situation, in welcher der Haltefuß des Behälters in dem Freiraum des Robotergreifers positioniert ist, in einer Verriegelungsstellung, in welcher der Robotergreifer relativ zum Haltefuß des Behälters gegenüber Fig. 7a um 45 Grad gedreht ist,
- Fig. 8b: eine Momentaufnahme einer Situation, in welcher der Haltefuß des Behälters an dem Robotergreifer mittels eines Stellglieds des Robotergreifer in seiner Spannstellung fixiert ist, und
- Fig. 9: eine perspektivische Darstellung eines Ausschnitts eines Roboterarms zusammen mit einer zur Fig. 3 alternativen Ausführungsvariante eines erfindungsgemäßen Robotergreifers, bei dem der Sensor horizontal statt vertikal angeordnet und durch einen Umlenkspiegel ergänzt ist.

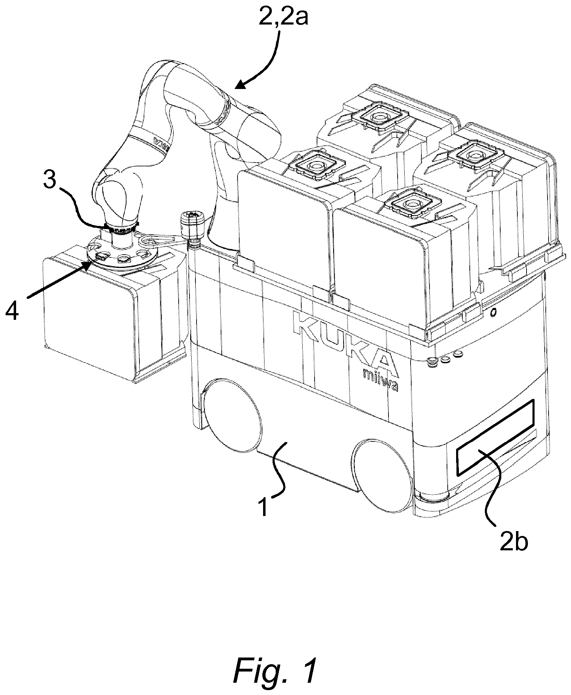

Die Fig. 1 zeigt in einer beispielhaften Handhabungssituation ein auf einem fahrerlosen Transportfahrzeug 1 angeordneter Roboter 2, der einen Roboterarm 2a und eine Robotersteuerung 2b umfasst. Der Roboterarm 2a weist einen Werkzeugflansch 3 auf, an dem ein erfindungsgemäßer Robotergreifer 4 befestigt ist, der ein beispielhaftes Objekt 5, vorliegend einen beispielhaften Behälter 5 greift.

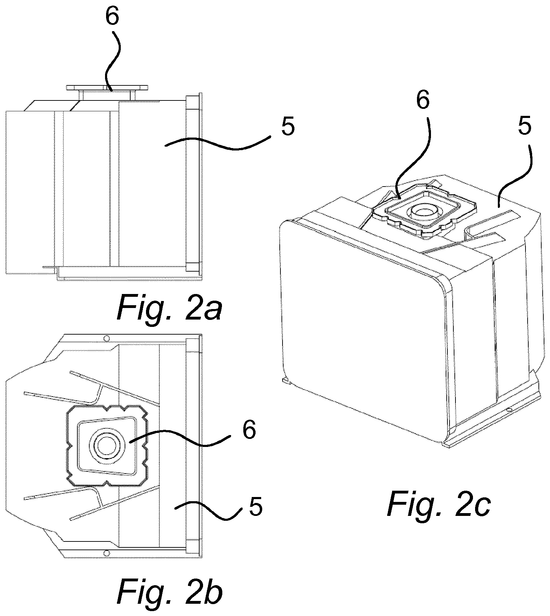

Wie aus Fig. 2 a bis Fig. 2c ersichtlich weist das Objekt 5 bzw. der Behälter 5 wenigstens einen, im Falle des vorliegenden Ausführungsbeispiels genau einen Haltefuß 6 auf. Die Fig. 1 zeigt mehrere solche Objekte 5 bzw. Behälter 5, von denen jedes Objekt 5 bzw. jeder Behälter 5 jeweils einen einzigen Haltefuß 6 aufweist.

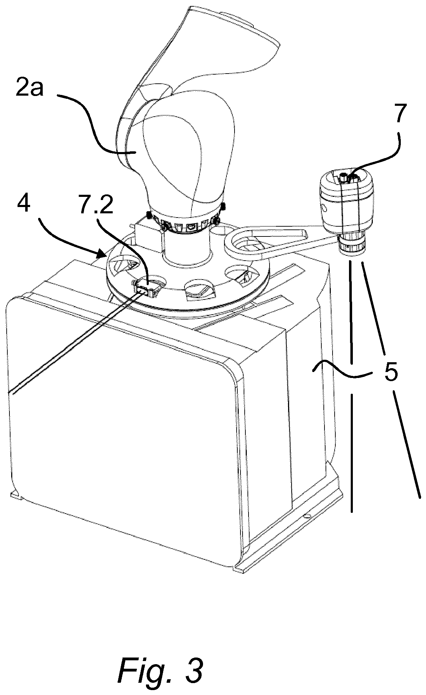

Die Fig. 3 zeigt einen Ausschnitt des Roboterarms 2a zusammen mit einer Ausführungsvariante des Robotergreifers 4 in einer Greifanordnung, bei der ein beispielhafter FOUP-Behälter 5 mittels seines Haltefußes 6 an dem Robotergreifer 4 befestigt ist. Der Robotergreifer 4 trägt im Falle dieses Ausführungsbeispiels einen Sensor 7, beispielsweise in Form einer Kamera, der ausgebildet ist, die relative Stellung des Robotergreifers 4 bezüglich des Objekts 5 bzw. Behälters 5 in wenigstens einer Messgröße, z.B. hinsichtlich eines Abstands A des Robotergreifers 4 zu einer Oberfläche des Behälters 5 und/oder zu einer Seitenkontur, insbesondere Seitenkonturkante des Behälters 5 zu erfassen.

In Fig. 3 ist der Sensor 7 als eine Kamera ausgebildet, die mit ihrer optischen Achse parallel zu einer seitlichen Längskante des Objekts 5 verlaufend ausgerichtet ist.

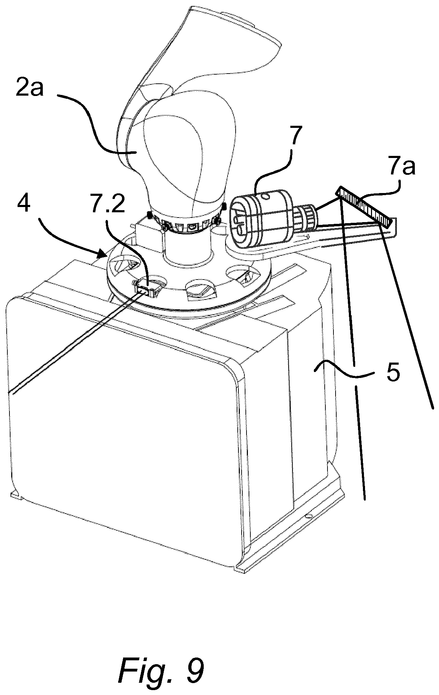

Alternativ kann, wie in Fig. 9 aufgezeigt ist, der Sensor 7 als eine Kamera ausgebildet sein, die mit ihrer optischen Achse quer zu einer seitlichen Längskante des Objekts 5 verlaufend ausgerichtet ist, wobei der Robotergreifer 4 dabei wenigstens einen Umlenkspiegel 7a umfasst, der ausgebildet ist, zum Umlenken von Licht aus einer parallel zu einer seitlichen Längskante des Objekts 5 verlaufenden Richtung in die quer zu der seitlichen Längskante des Objekts 5 verlaufenden Richtung, in der sich die optische Achse der Kamera erstreckt. Bei dieser zur Fig. 3 alternativen Ausführungsvariante der Fig. 9 ist der Sensor mit seiner optischen Achse horizontal statt vertikal angeordnet und durch den Umlenkspiegel 7a ergänzt.

In allen Varianten, d.h. auch jeweils in der Variante der Fig. 3 und Fig. 9, kann der Robotergreifer 4 einen zweiten Sensor 7.2 aufweisen, der ausgebildet und derart angeordnet ist, dass er einen seitlich eines durch den Robotergreifer 4 gegriffenen Objekts 5 vorhandenen Raum auf Hindernisse überwacht.

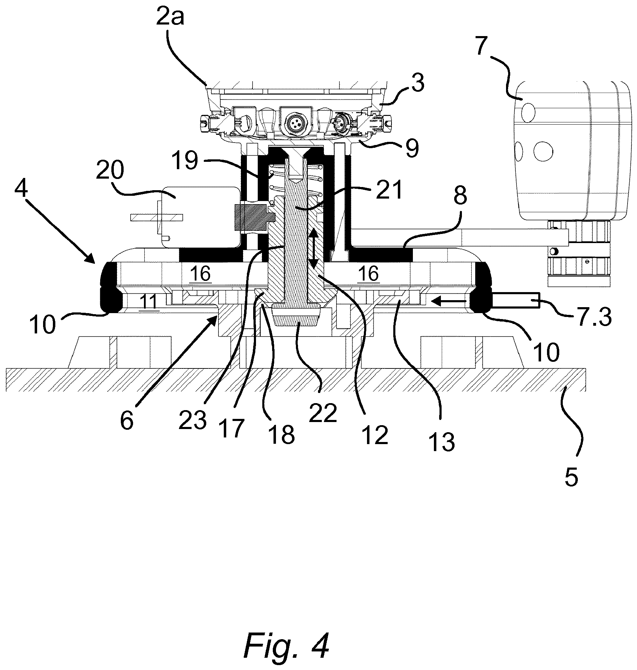

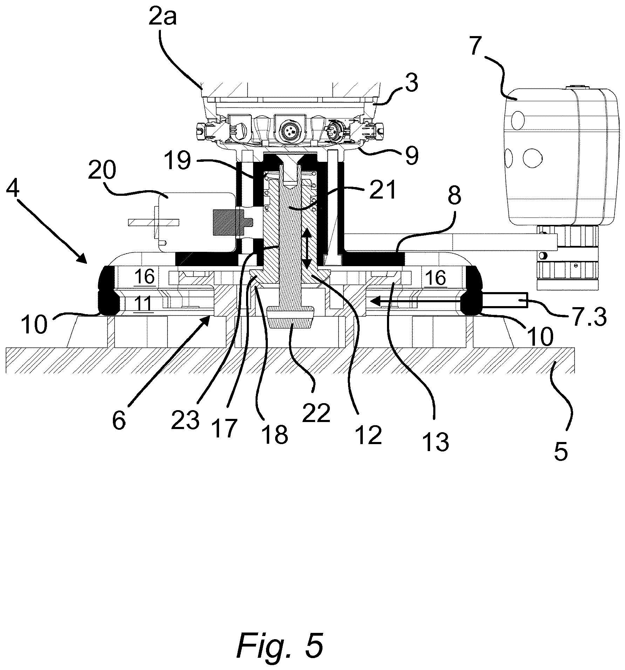

Wie insbesondere in Fig. 4 und Fig. 5 ersichtlich, kann der Robotergreifer 4 einen dritten Sensor 7.3 aufweisen, der ausgebildet und derart angeordnet ist, dass er das Vorhandensein des Objekts 5, insbesondere des Haltefußes 6 des Objekts 5 am Gegenhalter 10 des Robotergreifers 4 überwacht. Dazu kann der dritte Sensor 7.3, wie in Fig. 4 und Fig. 5 dargestellt, beispielsweise an dem Gegenhalter 10 angeordnet sein und nach innen ausgerichtet sein, so dass mittels des dritten Sensors 7.3 das Vorhandensein des Kopfabschnitts 13 des Haltefußes 6 des Behälters 5 und/oder das Vorhandensein des zwischen dem Behälter 5 und dem Haltefuß 6 ausgebildeten Verbindungsschaftes innerhalb des Gegenhalters 10 festgestellt werden kann.

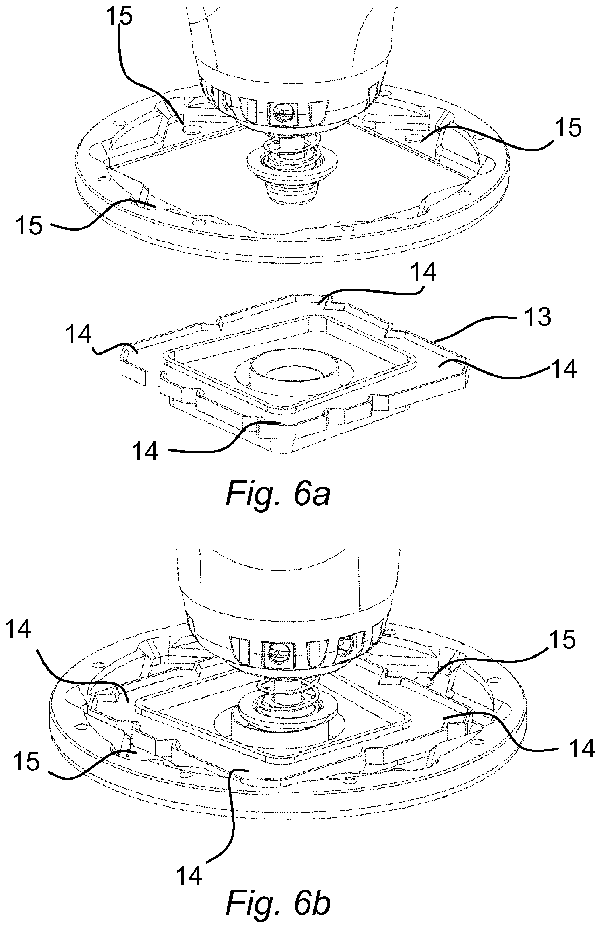

Wie insbesondere in Fig. 4 und Fig. 5 dargestellt ist, dient der Robotergreifer 4 zum Handhaben von wenigstens einen Haltefuß 6 aufweisenden Behältern 5 mittels eines Roboters 2. Der Robotergreifer 4 weist einen Greifergrundkörper 8 auf, der einen Anschlussflansch 9 aufweist, der zur Befestigung des Robotergreifers 4 an dem Werkzeugflansch 3 des Roboterarms 2a ausgebildet ist. Der Robotergreifer 4 weist des Weiteren einen mit dem Greifergrundkörper 8 verbundenen Gegenhalter 10 auf, der einen Ausschnitt 11 aufweist, welcher in seiner Form und Größe an den Haltefuß 6 des Behälter 5 angepasst ist, wie dies insbesondere in Fig. 6a bis Fig. 8b veranschaulicht ist.

Am Greifergrundkörper 8 ist ein Stellglied 12 verstellbar gelagert, welches ausgebildet ist, in einer Spannstellung (Fig. 4) gegen den Haltefuß 6 des Behälters 5 zu drücken, um diesen Behälter 5 gegen den Gegenhalter 10 zu fixieren, wie dies insbesondere in Fig. 4 veranschaulicht ist. In einer Freigabestellung, wie dies insbesondere in Fig. 5 veranschaulicht ist, wird der Haltefuß 6 durch das Stellglied 12 freigegeben, derart, dass der Gegenhalter 10 relativ zum Haltefuß 6 verstellbar ist, um den Haltefuß 6 des Behälters 5 von dem Robotergreifer 4 lösen zu können.

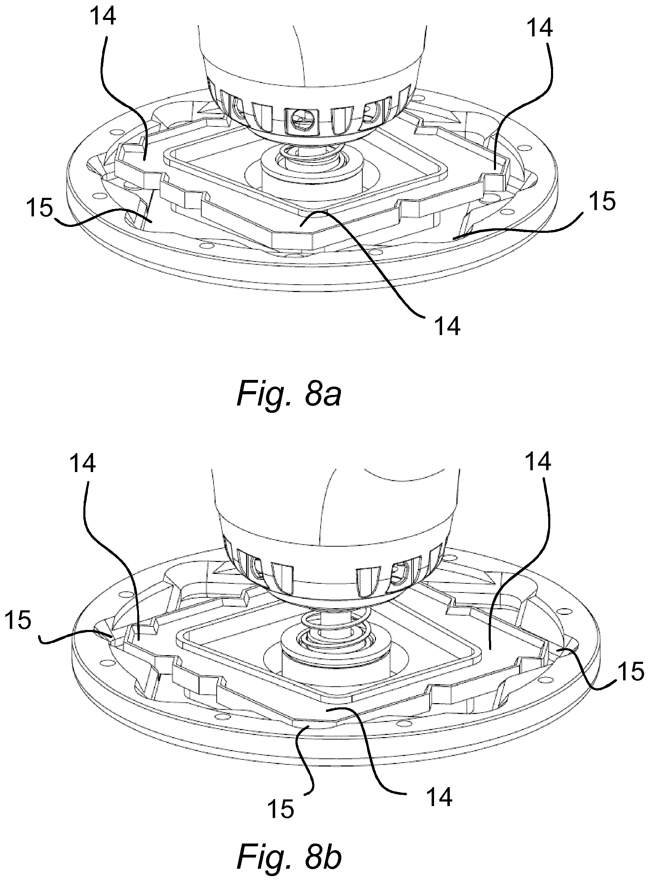

Der Ausschnitt 11 des Gegenhalters 10 ist als eine umfangsrandgeschlossener Fensterausschnitt ausgebildet, wobei die Innenkontur des Fensterausschnitts einer Außenkontur eines Kopfabschnitts 13 des Haltefußes 6 des Behälters 5 zumindest im Wesentlichen entspricht, wie dies auch in Fig. 6a bis Fig. 8b ersichtlich ist. Die Außenkontur des Kopfabschnitts 13 des Haltefußes weist dabei eine Konturgestalt auf, welche wenigstens einen Vorsprung 14 bildet, der in einer Verriegelungsstellung des Robotergreifers 4 wenigstens eine Rastnische 15 des Gegenhalters 10 hintergreift, wie dies in Fig. 8b der Fall ist.

Der Gegenhalter 10 ist in einem Abstand von dem Greifergrundkörper 8 am Robotergreifer 4 befestigt, derart, dass zwischen dem Gegenhalter 10 und dem Greifergrundkörper 8 ein Freiraum 16 (Fig. 4 und Fig. 5) gebildet wird, der ausgebildet ist, zum Drehen des Robotergreifers 4 relativ zum Haltefuß 6 des Behälters 5, wenn der Kopfabschnitt 13 des Haltefußes 6 über den Ausschnitt 11 des Gegenhalters 4 hinweg in den Freiraum 16 des Robotergreifers 4 eingetaucht ist, wie dies insbesondere in Fig. 5 gezeigt ist.

Der Gegenhalter 10 weist eine dem Greifergrundkörper 8 zugewandte Innenwand auf, die wenigstens eine Rastnische 15 für den Kopfabschnitt 13 des Haltefußes 6 des Behälters 5 oder des wenigstens einen Vorsprungs 14 des Kopfabschnitts 13 des Haltefußes 6 des Behälters 5 bildet.

Das Stellglied 12 ist ein im Zentrum des Robotergreifers 4 angeordneter bzw. axial verstellbar gelagerter Druckstempel, der einen Stempelkopf 17 aufweist, der zum Drücken gegen einen korrespondierenden Sitz 18 am Kopfabschnitt 13 des Haltefußes 6 des Behälters 5 ausgebildet ist.

Das Stellglied 12 ist mittels einer Federvorrichtung 19 federvorgespannt am Greifergrundkörper 8 gelagert, derart, dass durch die Federvorrichtung 19 eine Federkraft erzeugt wird, welche das Stellglied 12 in seiner Spannstellung selbsttätig gegen den Kopfabschnitt 13 bzw. den Sitz 18 des Haltefußes 6 des Behälters 5 drückt.

Der Robotergreifer 4 weist im Falle des vorliegenden Ausführungsbeispiels eine optionale Sicherungsvorrichtung 20 auf, die ausgebildet ist, das Stellglied 12 in seiner Spannstellung automatisch zu arretieren.

Außerdem kann der Robotergreifer 4 im Falle des vorliegenden Ausführungsbeispiels einen optionalen Zentrierstift 21 aufweisen, der an seinem freien Stirnende einen Zentrierkonus 22 aufweist. Außerdem kann der Robotergreifer 4 im Falle des vorliegenden Ausführungsbeispiels einen optionalen Zentrierstift 21 aufweisen, der eine Führung 23 bildet, an der das Stellglied 12 axial verstellbar geführt ist.

Die Fig. 6a zeigt eine Momentaufnahme einer Situation, in welcher der Robotergreifer mit dem Haltefuß des Behälters fluchtet. Dies entspricht dem Verfahrensschritt des Heranführens des Robotergreifers 4 an den Haltefuß 6 des aufzunehmenden Behälters 5 durch Bewegen des Roboterarms 2a des Roboters 2, automatisch angesteuert durch die Robotersteuerung 2b des Roboterarms 2a, die ausgebildet ist, die Glieder des Roboterarms 2a durch Verstellen der die Glieder des Roboterarms 2a verbindenden Gelenke des Roboterarms 2a automatisch zu bewegen, bis der Ausschnitt 11 des Gegenhalters 10 des Robotergreifers 4 mit dem Haltefuß 6 fluchtet.

Die Fig. 6b zeigt eine Momentaufnahme einer Situation, in welcher der Haltefuß 6 des Behälters 5 in den Ausschnitt 11 des Robotergreifers 4 eindringt. Dies entspricht dem Verfahrensschritt des Drückens des Robotergreifers 4 gegen den Haltefuß 6 des Behälters 5 derart, dass der Kopfabschnitt 13 des Haltefußes 6 durch den Ausschnitt 11 des Gegenhalters 10 hindurch in den Freiraum 16 des Robotergreifers 4 eindringt.

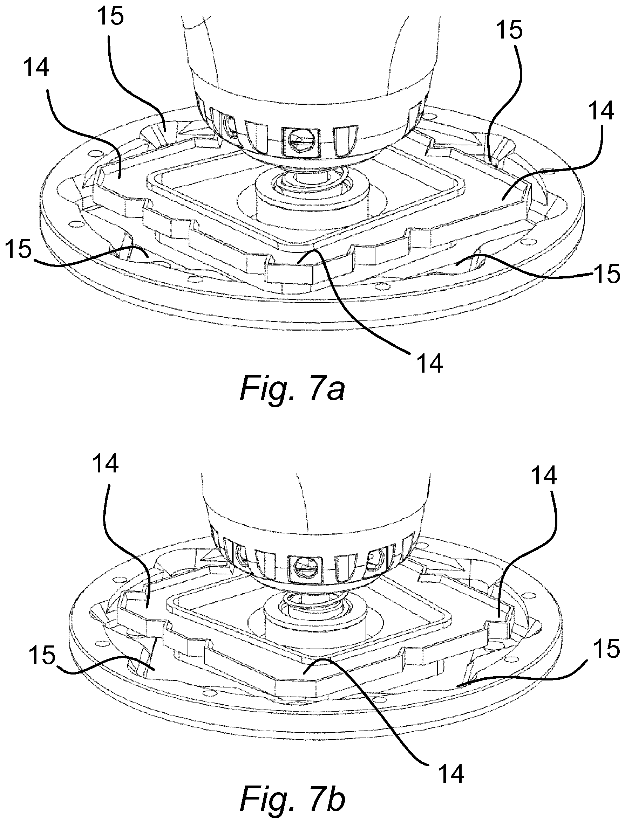

Die Fig. 7a zeigt eine Momentaufnahme einer Situation, in welcher der Haltefuß 6 des Behälters 5 in dem Freiraum 16 des Robotergreifer 4 positioniert ist, in einer Entriegelungsstellung, zum Drehen des Robotergreifers 4 relativ zum Haltefuß 6 des Behälters 5.

Die Fig. 7b und Fig. 8a zeigen in identischer Weise eine Momentaufnahme einer Situation, in welcher der Haltefuß 6 des Behälters 5 in dem Freiraum 16 des Robotergreifers 4 positioniert ist, in einer Verriegelungsstellung, in welcher der Robotergreifer 4, insbesondere der Gegenhalter 10 relativ zum Haltefuß 6 des Behälters 5 gegenüber Fig. 7a um 45 Grad gedreht ist.

Zwischen den Momentaufnahmen gemäß der Fig. 7a und Fig. 7b erfolgt demgemäß der Verfahrensschritt des Drehens des Robotergreifers 4 relativ zum Haltefuß 6 des Behälters 5 durch Bewegen des Roboterarms 2a, automatisch angesteuert durch die Robotersteuerung 2b, die ausgebildet ist, die Glieder des Roboterarms 2a durch Verstellen der die Glieder des Roboterarms 2a verbindenden Gelenke des Roboterarms 2a automatisch zu bewegen, bis wenigstens ein Vorsprung 14, im Falle des vorliegenden Ausführungsbeispiel die vier Vorsprünge 14 des Kopfabschnitts 13 des Haltefußes 6 den Ausschnitt 11 des Gegenhalters 10 hintergreifen und in wenigstens einer Rastnische 15, im Falle des vorliegenden Ausführungsbeispiel die vier Rastnische 15 des Gegenhalters 10 einschwenken.

Die Fig. 8b zeigt abschließend eine Momentaufnahme einer Situation, in welcher der Haltefuß 6 des Behälters 5 an dem Robotergreifer 4 mittels des Stellglieds 12 des Robotergreifer 4 in seiner Spannstellung fixiert ist. Dies entspricht dem Verfahrensschritt des Fixierens des Behälters 5 bezüglich des Robotergreifers 4 in einer Anordnung, in welcher der wenigstens eine Vorsprung 14 bzw. die vier Vorsprünge 14 des Kopfabschnitts 13 des Haltefußes 5 den Ausschnitt 11 des Gegenhalters 10 hintergreifen und in die wenigstens eine Rastnische 15 bzw. die vier Rastnischen 15 des Gegenhalters 10 eingeschwenkt sind, durch Drücken des verstellbaren Stellglieds 12 des Robotergreifers 4 gegen den Haltefuß 13 bzw. gegen den Sitz 18 des Behälters 5.

Der Schutzbereich des europäischen Patents wird durch die Patentansprüche bestimmt. Die Beschreibung und die Zeichnungen sind jedoch zur Auslegung der Patentansprüche heranzuziehen.

## Patentansprüche

1. Robotergreifer zum Handhaben von jeweils wenigstens ein Haltefuß (6) aufweisenden Objekten (5), insbesondere Behälter (5) mittels eines Roboters (2), aufweisend einen Greifergrundkörper (8), der einen Anschlussflansch (9) aufweist, der zur Befestigung des Robotergreifers (4) an einem Werkzeugflansch (3) eines Roboterarms (2a) ausgebildet ist, des Weiteren aufweisend einen mit dem Greifergrundkörper (8) verbundenen Gegenhalter (10), der einen Ausschnitt (11) aufweist, welcher in seiner Form und Größe an den Haltefuß (6) des Objekts (5) angepasst ist, um diesen formschlüssig aufnehmen zu können, und ein am Greifergrundkörper (8) angeordnetes, bevorzugt verstellbar gelagertes, Stellglied (12), welches ausgebildet ist, in einer Spannstellung gegen den Haltefuß (6) des Objekts (5) zu drücken, um diesen gegen den Gegenhalter (10) zu fixieren und in einer Freigabestellung den Haltefuß (6) freizugeben, derart, dass der Gegenhalter (10) relativ zum Haltefuß (6) verstellbar ist, um den Haltefuß (6) des Objekts (5) von dem Robotergreifer (4) lösen zu können,
wobei der Ausschnitt (11) des Gegenhalters (10) als eine umfangsrandgeschlossener Fensterausschnitt ausgebildet ist, wobei die Innenkontur des Fensterausschnitts einer Außenkontur eines Kopfabschnitts (13) des Haltefußes (6) des Objekts (5) zumindest im Wesentlichen entspricht und die Außenkontur des Kopfabschnitts (13) des Haltefußes (6) eine Konturgestalt aufweist, welche wenigstens einen Vorsprung (14) bildet, der in einer Verriegelungsstellung des Robotergreifers (4) wenigstens eine Rastnische (15) des Gegenhalters (10) hintergreift, wobei der Gegenhalter (10) eine dem Greifergrundkörper (8) zugewandte Innenwand aufweist, die wenigstens eine Rastnische (15) für den Kopfabschnitt (13) des Haltefußes (6) des Objekts (5) oder des wenigstens einen Vorsprungs (14) des Kopfabschnitts (13) des Haltefußes (6) des Objekts (5) bildet.

2. Robotergreifer nach Anspruch 1, **dadurch gekennzeichnet, dass** der Gegenhalter (10) in einem Abstand von dem Greifergrundkörper (8) am Robotergreifer (4) befestigt ist, derart, dass zwischen dem Gegenhalter (10) und dem Greifergrundkörper (8) ein Freiraum (16) gebildet wird, der ausgebildet ist, zum Drehen des Robotergreifers (4) relativ zum Haltefuß (6) des Objekts (5), wenn der Kopfabschnitt (13) des Haltefußes (6) über den Ausschnitt (11) des Gegenhalters (10) hinweg in den Freiraum (16) des Robotergreifers (4) eingetaucht ist.

3. Robotergreifer nach einem der Ansprüche 1 bis 2, **dadurch gekennzeichnet, dass** das Stellglied (12) ein im Zentrum des Robotergreifers (4) axial verstellbar gelagerter Druckstempel ist, der einen Stempelkopf (17) aufweist, der zum Drücken gegen einen korrespondierenden Sitz (18) am Kopfabschnitt (13) des Haltefußes (6) des Objekts (5) ausgebildet ist.

4. Robotergreifer nach einem der Ansprüche 1 bis 3, **dadurch gekennzeichnet, dass** das Stellglied (12) mittels einer Federvorrichtung (19) federvorgespannt am Greifergrundkörper (8) gelagert ist, derart, dass durch die Federvorrichtung (19) eine Federkraft erzeugt wird, welche das Stellglied (12) in seiner Spannstellung selbsttätig gegen den Kopfabschnitt (13) des Haltefußes (6) des Objekts (5) drückt.

5. Robotergreifer nach einem der Ansprüche 1 bis 4, **dadurch gekennzeichnet, dass** der Robotergreifer (4) einen Zentrierstift (21) aufweist, der an seinem freien Stirnende einen Zentrierkonus (22) aufweist, und/oder der Zentrierstift (21) eine Führung (23) bildet, an der das Stellglied (12) axial verstellbar geführt ist.

6. Robotergreifer nach einem der Ansprüche 1 bis 5, **dadurch gekennzeichnet, dass** der Robotergreifer (4) wenigstens einen Sensor (7) aufweist, der ausgebildet ist, die relative Stellung des Robotergreifers (4) bezüglich des Objekts (5) in wenigstens einer Messgröße zu erfassen.

7. Robotergreifer nach Anspruch 6, **dadurch gekennzeichnet, dass** der Sensor (7) als eine Kamera ausgebildet ist, die mit ihrer optischen Achse parallel zu einer seitlichen Längskante des Objekts (5) verlaufend ausgerichtet ist.

8. Robotergreifer nach Anspruch 7, **dadurch gekennzeichnet, dass** der Sensor (7) als eine Kamera ausgebildetist, die mit ihrer optischen Achse quer zu einer seitlichen Längskante des Objekts (5) verlaufend ausgerichtet ist und der Robotergreifer (4) wenigstens einen Umlenkspiegel (7a) umfasst, der ausgebildet ist, zum Umlenken von Licht aus einer parallel zu einer seitlichen Längskante des Objekts (5) verlaufenden Richtung in die quer zu der seitlichen Längskante des Objekts (5) verlaufenden Richtung, in der sich die optische Achse der Kamera erstreckt.

9. Robotergreifer nach einem der Ansprüche 1 bis 8, **dadurch gekennzeichnet, dass** der Robotergreifer (4) einen zweiten Sensor (7.2) aufweist, der ausgebildet und derart angeordnet ist, dass er einen seitlich eines durch den Robotergreifer (4) gegriffenen Objekts (5) vorhandenen Raum auf Hindernisse überwacht.

10. Robotergreifer nach einem der Ansprüche 1 bis 9, **dadurch gekennzeichnet, dass** der Robotergreifer (4) einen dritten Sensor (7.3) aufweist, der ausgebildet und derart angeordnet ist, dass er das Vorhandensein des Objekts (5), insbesondere des Haltefußes (6) des Objekts (5) am Gegenhalter (10) des Robotergreifers (4) überwacht.

11. Verfahren zum Handhaben von jeweils wenigstens einen Haltefuß (6) aufweisenden Objekten (5), insbesondere Behälter (5) mittels eines Roboters (2), aufweisend die Schritte:
- Heranführen eines Robotergreifers (4) an einen Haltefuß (6) eines aufzunehmenden Objekts (5) durch Bewegen eines Roboterarms (2a) des Roboters (2), automatisch angesteuert durch eine Robotersteuerung (2b) des Roboterarms (2a), die ausgebildet ist, die Glieder des Roboterarms (2a) durch Verstellen der die Glieder des Roboterarms (2a) verbindenden Gelenke des Roboterarms (2a) automatisch zu bewegen, bis ein Ausschnitt (11) eines Gegenhalters (10) des Robotergreifers (4) mit dem Haltefuß (6) fluchtet,
- Drücken des Robotergreifers (4) gegen den Haltefuß (6) des Objekts (5) derart, dass ein verstellbares Stellglied (12) des Robotergreifers (4) gegen den Haltefuß (6) des Objekts (5) gedrückt wird, durch das Drücken verstellt wird und in Folge dessen eine Vorspannung zwischen Stellglied (12) und Gegenhalters (10) erzeugt wird, und dabei ein Kopfabschnitt (13) des Haltefußes (6) durch den Ausschnitt (11) des Gegenhalters (10) hindurch in einen Freiraum (16) des Robotergreifers (4) eindringt,
- Drehen des Robotergreifers (4) relativ zum Haltefuß (6) des Objekts (5) durch Bewegen des Roboterarms (2a), automatisch angesteuert durch die Robotersteuerung (2b), die ausgebildet ist, die Glieder des Roboterarms (2a) durch Verstellen der die Glieder des Roboterarms (2a) verbindenden Gelenke des Roboterarms (2a) automatisch zu bewegen, bis wenigstens ein Vorsprung (14) des Kopfabschnitts (13) des Haltefußes (6) den Ausschnitt (11) des Gegenhalters (10) hintergreift und in wenigstens einer Rastnische (15) des Gegenhalters (10) einschwenkt,
- Fixieren des Objekts (5) bezüglich des Robotergreifers (4) in einer Anordnung, in welcher der wenigstens eine Vorsprung (14) des Kopfabschnitts (13) des Haltefußes (6) den Ausschnitt (11) des Gegenhalters (10) hintergreift und in die wenigstens eine Rastnische (15) des Gegenhalters (10) eingeschwenkt ist, durch ein zum Drücken entgegengesetztes Bewegen des Robotergreifers (4), sodass eine verbleibende Vorspannung des Stellglieds (12) den Haltefuß (6) zwischen dem Stellglied (12) und dem Gegenhalter (10) verspannt.

12. Verfahren nach Anspruch 11, **dadurch gekennzeichnet, dass** in der Anordnung, in welcher der wenigstens eine Vorsprung (14) des Kopfabschnitts (13) des Haltefußes (6) den Ausschnitt (11) des Gegenhalters (10) hintergreift und in die wenigstens eine Rastnische (15) des Gegenhalters (10) eingeschwenkt ist, und durch Drücken des verstellbaren Stellglieds (12) des Robotergreifers (4) gegen den Haltefuß (6) des Objekts (5) das Objekt(5) bezüglich des Robotergreifers (4) fixiert ist, das Stellglied (12) mittels einer Sicherungsvorrichtung (20) automatisch arretiert wird.

13. Verfahren nach Anspruch 11 oder 12, **dadurch gekennzeichnet, dass** das Heranführen des Robotergreifers (4) an den Haltefuß (6) des aufzunehmenden Objekts (5) durch Bewegen des Roboterarms (2a) des Roboters (2), automatisch angesteuert durch die Robotersteuerung (2b), die ausgebildet ist, die Glieder des Roboterarms (2a) durch Verstellen der die Glieder des Roboterarms (2a) verbindenden Gelenke des Roboterarms (2a) automatisch zu bewegen, bis ein Ausschnitt (11) des Gegenhalters (10) mit dem Haltefuß (6) fluchtet, dadurch unterstützt wird, dass ein am Robotergreifer (4) befestigter Zentrierstift (21) in einem durch die Robotersteuerung (2b) kraft-/momentregelten Betrieb des Roboterarms (2a) in einer den Kopfabschnitt (13) des Haltefußes (6) des Behälters (5) berührenden Weise an das Objekt (5) herangeführt wird, bis der Ausschnitt (11) des Gegenhalters (10) mit dem Kopfabschnitt (13) des Haltefußes (6) des Objekts (5) fluchtet.

14. Verfahren nach einem der Ansprüche 11 bis 13, **dadurch gekennzeichnet, dass** das Heranführen des Robotergreifers (4) an den Haltefuß (6) des aufzunehmenden Objekts (5) durch Bewegen des Roboterarms (2a) des Roboters (2), automatisch angesteuert durch die Robotersteuerung (2b), die ausgebildet ist, die Glieder des Roboterarms (2a) durch Verstellen der die Glieder des Roboterarms (2a) verbindenden Gelenke des Roboterarms (2a) automatisch zu bewegen, bis ein Ausschnitt (11) des Gegenhalters (10) mit dem Haltefuß (6) fluchtet, durch wenigstens einen an dem Robotergreifer (4) angeordneten Sensor (7) unterstützt wird, der wenigstens eine Messgröße einer relativen Stellung des Robotergreifers (4) bezüglich des Objekts (5) erfasst und zur automatischen Ansteuerung des Roboterarms (2a) mittels der Robotersteuerung (2b) auf Grundlage der wenigstens einen erfassten Messgröße an die Robotersteuerung (2b) übermittelt.

15. Verfahren nach einem der Ansprüche 11 bis 14, **dadurch gekennzeichnet, dass** das Verfahren mittels eines Roboters (2) durchgeführt wird, dessen Werkzeugflansch (3) einen Robotergreifer (4) nach einem der Ansprüche 1 bis 13 trägt.

## Claims

1. Robot gripper for handling objects (5), in particular containers (5), each having at least one holding foot (6), by means of a robot (2), having a gripper base body (8) which has a connecting flange (9), which is designed for fastening the robot gripper (4) to a tool flange (3) of a robot arm (2a), further comprising a counterholder (10) which is connected to the gripper base body (8) and has a cutout (11) which is adapted in its shape and size to the holding foot (6) of the object (5), in order to be able to receive it in a form-fitting manner, and an actuator (12) which is arranged on the gripper base body (8), is preferably mounted adjustably and is designed to press against the holding foot (6) of the object (5) in a clamping position, in order to fix the latter against the counterholder (10) and, in a release position, to release the holding foot (6) in such a way that the counterholder (10) can be adjusted relative to the holding foot (6) in order to be able to release the holding foot (6) of the object (5) from the robot gripper (4),
wherein the cutout (11) of the counterholder (10) is formed as a window cutout closed at the circumferential edge, wherein the inner contour of the window cutout corresponds at least substantially to an outer contour of a head portion (13) of the holding foot (6) of the object (5) and the outer contour of the head portion (13) of the holding foot (6) has a contour shape which forms at least one projection (14), which, in a locking position of the robot gripper (4), engages behind at least one latching niche (15) of the counterholder (10), the counterholder (10) having an inner wall which faces the gripper base body (8) and forms at least one latching niche (15) for the head portion (13) of the holding foot (6) of the object (5) or of the at least one projection (14) of the head portion (13) of the holding foot (6) of the object (5).

2. Robot gripper according to claim 1, **characterised in that** the counterholder (10) is attached to the robot gripper (4) at a distance from the gripper base body (8) in such a way that a free space (16) is formed between the counterholder (10) and the gripper base body (8), which is designed to rotate the robot gripper (4) relative to the holding foot (6) of the object (5) when the head portion (13) of the holding foot (6) is immersed in the free space (16) of the robot gripper (4) beyond the cutout (11) of the counterholder (10).

3. Robot gripper according to any one of claims 1 to 2, **characterised in that** the actuator (12) is a pressure plunger axially adjustably mounted in the centre of the robot gripper (4) and having a plunger head (17) adapted to press against a corresponding seat (18) on the head portion (13) of the holding foot (6) of the object (5).

4. Robot gripper according to one of claims 1 to 3, **characterised in that** the actuator (12) is mounted on the gripper base body (8) in a spring-biased manner by means of a spring device (19) in such a way that a spring force is generated by the spring device (19) which automatically presses the actuator (12) in its biased position against the head portion (13) of the holding foot (6) of the object (5).

5. Robot gripper according to one of claims 1 to 4, **characterised in that** the robot gripper (4) has a centring pin (21) which has a centring cone (22) at its free end face, and/or the centring pin (21) forms a guide (23) on which the actuator (12) is axially adjustably guided.

6. Robot gripper according to one of claims 1 to 5, **characterised in that** the robot gripper (4) has at least one sensor (7) which is designed to detect the relative position of the robot gripper (4) with respect to the object (5) in at least one measured variable.

7. Robot gripper according to claim 6, **characterised in that** the sensor (7) is designed as a camera which is aligned with its optical axis running parallel to a lateral longitudinal edge of the object (5).

8. Robot gripper according to claim 7, **characterised in that** the sensor (7) is designed as a camera which is aligned with its optical axis extending transversely to a lateral longitudinal edge of the object (5) and the robot gripper (4) comprises at least one deflecting mirror (7a) which is designed to deflect light from a direction extending parallel to a lateral longitudinal edge of the object (5) into the direction extending transversely to the lateral longitudinal edge of the object (5) in which the optical axis of the camera extends.

9. Robot gripper according to any one of claims 1 to 8, **characterised in that** the robot gripper (4) has a second sensor (7.2) which is designed and arranged to monitor for obstacles in a space to the side of an object (5) gripped by the robot gripper (4).

10. Robot gripper according to one of claims 1 to 9, **characterised in that** the robot gripper (4) has a third sensor (7.3) which is designed and arranged in such a way that it monitors the presence of the object (5), in particular of the holding foot (6) of the object (5) on the counterholder (10) of the robot gripper (4).

11. Method for handling objects (5), in particular containers (5), each having at least one holding foot (6), by means of a robot (2), having the steps:
- bringing a robot gripper (4) to a holding foot (6) of an object (5) to be picked up by moving a robot arm (2a) of the robot (2), automatically controlled by a robot controller (2b) of the robot arm (2a), which is designed to move the robot arm (2a) in the direction of the holding foot (6), automatically moving the links of the robot arm (2a) by adjusting the joints of the robot arm (2a) connecting the links of the robot arm (2a) until a cutout (11) of a counterholder (10) of the robot gripper (4) is aligned with the holding foot (6),
- pressing the robot gripper (4) against the holding foot (6) of the object (5) such that an adjustable actuator (12) of the robot gripper (4) is pressed against the holding foot (6) of the object (5), is adjusted by the pressing and, as a result, a pretension is generated between the actuator (12) and the counterholder (10), and a head portion (13) of the holding foot (6) penetrates through the cutout (11) of the counterholder (10) into a free space (16) of the robot gripper (4),
- rotating the robot gripper (4) relative to the holding foot (6) of the object (5) by moving the robot arm (2a), automatically controlled by the robot controller (2b), which is designed to automatically move the links of the robot arm (2a) by adjusting the joints of the robot arm (2a) connecting the links of the robot arm (2a), until at least one projection (14) of the head portion (13) of the holding foot (6) engages behind the cutout (11) of the counterholder (10) and pivots into at least one catch niche (15) of the counterholder (10),
- fixing the object (5) with respect to the robot gripper (4) in an arrangement in which the at least one projection (14) of the head portion (13) of the holding foot (6) engages behind the cutout (11) of the counterholder (10) and is pivoted into the at least one latching niche (15) of the counterholder (10), by moving the robot gripper (4) in the opposite direction to pressing, so that a remaining pre-tension of the actuator (12) braces the holding foot (6) between the actuator (12) and the counterholder (10).

12. Method according to claim 11, **characterised in that** in the arrangement in which the at least one projection (14) of the head portion (13) of the holding foot (6) engages behind the cutout (11) of the counterholder (10) and is pivoted into the at least one detent niche (15) of the counterholder (10), and by pressing the adjustable actuator (12) of the robot gripper (4) against the holding foot (6) of the object (5), the object (5) is fixed with respect to the robot gripper (4), the actuator (12) is automatically locked by means of a locking device (20).

13. Method according to claim 11 or 12, **characterized in that** the approach of the robot gripper (4) to the holding foot (6) of the object (5) to be picked up is performed by moving the robot arm (2a) of the robot (2), automatically controlled by the robot controller (2b), which is adapted to automatically move the links of the robot arm (2a) by adjusting the joints of the robot arm (2a) connecting the links of the robot arm (2a), until a cutout (11) of the counterholder (10) is aligned with the holding foot (6) by assisting a centering pin (21) attached to the robot gripper (4) to approach the object (5) in a force/torque controlled operation of the robot arm (2a) by the robot controller (2b) in a manner contacting the head portion (13) of the holding foot (6) of the container (5), until the cutout (11) of the counterholder (10) is aligned with the head portion (13) of the holding foot (6) of the object (5).

14. Method according to one of the claims 11 to 13, **characterized in that** the bringing of the robot gripper (4) to the holding foot (6) of the object (5) to be picked up by moving the robot arm (2a) of the robot (2), automatically controlled by the robot controller (2b), which is designed to automatically move the links of the robot arm (2a) by adjusting the joints of the robot arm (2a) connecting the links of the robot arm (2a), until a cutout (11) of the counterholder (10) is aligned with the holding foot (6), is supported by at least one sensor (7) which is arranged on the robot gripper (4), detects at least one measured variable of a relative position of the robot gripper (4) with respect to the object (5) and transmits it to the robot controller (2b) for automatic activation of the robot arm (2a) by means of the robot controller (2b) on the basis of the at least one detected measured variable.

15. Method according to any one of claims 11 to 14, **characterized in that** the method is carried out by means of a robot (2) whose tool flange (3) carries a robot gripper (4) according to any one of claims 1 to 13.

## Revendications

1. Pince de robot pour la manipulation d'objets (5) présentant chacun au moins un pied de maintien (6), en particulier des récipients (5) au moyen d'un robot (2), présentant un corps de base de pince (8) qui présente une bride de raccordement (9), qui est conçue pour la fixation de la pince de robot (4) sur une bride d'outil (3) d'un bras de robot (2a), présentant en outre un contre-support (10) relié au corps de base de la pince (8), qui présente une découpe (11) dont la forme et la taille sont adaptées au pied de maintien (6) de l'objet (5), pour pouvoir recevoir celui-ci par complémentarité de forme, et un organe de réglage (12) disposé sur le corps de base de la pince (8), de préférence monté de manière réglable, qui est conçu pour appuyer contre le pied de maintien (6) de l'objet (5) dans une position de serrage, pour fixer celui-ci contre le contre-support (10) et pour libérer le pied de maintien (6) dans une position de libération, de telle sorte que le contre-support (10) est réglable par rapport au pied de maintien (6), afin de pouvoir détacher le pied de maintien (6) de l'objet (5) de la pince de robot (4),
la découpe (11) du contre-support (10) étant réalisée sous la forme d'une découpe de fenêtre fermée sur le bord périphérique, le contour intérieur de la découpe de fenêtre correspondant au moins sensiblement à un contour extérieur d'une section de tête (13) du pied de maintien (6) de l'objet (5) et le contour extérieur de la section de tête (13) du pied de maintien (6) présentant une forme de contour qui forme au moins une saillie (14), qui, dans une position de verrouillage de la pince de robot (4), s'engage derrière au moins une niche d'encliquetage (15) du contre-support (10), le contre-support (10) présentant une paroi intérieure tournée vers le corps de base de la pince (8), qui forme au moins une niche d'encliquetage (15) pour la section de tête (13) du pied de maintien (6) de l'objet (5) ou de la au moins une saillie (14) de la section de tête (13) du pied de maintien (6) de l'objet (5).

2. Pince de robot selon la revendication 1, **caractérisée en ce que** le contre-support (10) est fixé à la pince de robot (4) à une distance du corps de base de la pince (8), de telle sorte qu'un espace libre (16) est formé entre le contre-support (10) et le corps de base de la pince (8), qui est conçu pour faire tourner la pince de robot (4) par rapport au pied de maintien (6) de l'objet (5) lorsque la section de tête (13) du pied de maintien (6) est plongée dans l'espace libre (16) de la pince de robot (4) pardessus la découpe (11) du contre-support (10).

3. Pince de robot selon l'une des revendications 1 à 2, **caractérisée en ce que** l'organe de réglage (12) est un poinçon de pression monté de manière à pouvoir être déplacé axialement au centre de la pince de robot (4), qui présente une tête de poinçon (17) qui est conçue pour être pressée contre un siège correspondant (18) sur la section de tête (13) du pied de maintien (6) de l'objet (5).

4. Pince de robot selon l'une des revendications 1 à 3, **caractérisée en ce que** l'organe de réglage (12) est monté sur le corps de base de la pince (8) au moyen d'un dispositif à ressort (19), de telle sorte que le dispositif à ressort (19) génère une force élastique qui presse automatiquement l'organe de réglage (12) dans sa position de serrage contre la section de tête (13) du pied de maintien (6) de l'objet (5).

5. Pince de robot selon l'une des revendications 1 à 4, **caractérisée en ce que** la pince de robot (4) présente une broche de centrage (21) qui présente un cône de centrage (22) à son extrémité frontale libre, et/ou la broche de centrage (21) forme un guidage (23) sur lequel l'organe de réglage (12) est guidé de manière réglable axialement.

6. Pince de robot selon l'une des revendications 1 à 5, **caractérisée en ce que** la pince de robot (4) présente au moins un capteur (7) qui est conçu pour détecter la position relative de la pince de robot (4) par rapport à l'objet (5) dans au moins une grandeur de mesure.

7. Pince de robot selon la revendication 6, **caractérisée en ce que** le capteur (7) est conçu comme une caméra dont l'axe optique est orienté parallèlement à un bord longitudinal latéral de l'objet (5).

8. Pince de robot selon la revendication 7, **caractérisée en ce que** le capteur (7) est réalisé sous la forme d'une caméra qui est orientée avec son axe optique s'étendant transversalement à un bord longitudinal latéral de l'objet (5) et la pince de robot (4) comprend au moins un miroir de déviation (7a) qui est réalisé pour dévier la lumière d'une direction s'étendant parallèlement à un bord longitudinal latéral de l'objet (5) dans la direction s'étendant transversalement au bord longitudinal latéral de l'objet (5), dans laquelle s'étend l'axe optique de la caméra.

9. Pince de robot selon l'une des revendications 1 à 8, **caractérisée en ce que** la pince de robot (4) présente un deuxième capteur (7.2) qui est conçu et disposé de manière à surveiller la présence d'obstacles dans un espace présent sur le côté d'un objet (5) saisi par la pince de robot (4).

10. Pince de robot selon l'une des revendications 1 à 9, **caractérisée en ce que** la pince de robot (4) présente un troisième capteur (7.3) qui est conçu et disposé de manière à surveiller la présence de l'objet (5), en particulier du pied de maintien (6) de l'objet (5) sur le contre-support (10) de la pince de robot (4).

11. Procédé de manipulation d'objets (5) présentant chacun au moins un pied de maintien (6), en particulier des récipients (5) au moyen d'un robot (2), présentant les étapes suivantes :
- Approcher une pince de robot (4) d'un pied de maintien (6) d'un objet (5) à prendre en déplaçant un bras de robot (2a) du robot (2), commandé automatiquement par une commande de robot (2b) du bras de robot (2a), qui est conçue, de déplacer automatiquement les membres du bras de robot (2a) en réglant les articulations du bras de robot (2a) reliant les membres du bras de robot (2a) jusqu'à ce qu'une découpe (11) d'un contre-support (10) de la pince de robot (4) soit alignée avec le demi-pied (6),
- Pousser la pince de robot (4) contre le pied de maintien (6) de l'objet (5) de telle sorte qu'un élément de réglage (12) réglable de la pince de robot (4) soit pressé contre le pied de maintien (6) de l'objet (5), est déplacé par la pression et qu'en conséquence, une précontrainte est générée entre l'organe de réglage (12) et le contre-support (10), une section de tête (13) du pied de maintien (6) pénétrant alors dans un espace libre (16) de la pince de robot (4) à travers la découpe (11) du contre-support (10),
- la rotation de la pince de robot (4) par rapport au pied de maintien (6) de l'objet (5) par déplacement du bras de robot (2a), commandé de manière non automatique par la commande de robot (2b), qui est conçue pour déplacer automatiquement les éléments du bras de robot (2a) en réglant les articulations du bras de robot (2a) reliant les éléments du bras de robot (2a), jusqu'à ce qu'au moins une saillie (14) de la section de tête (13) du pied de maintien (6) s'engage derrière la découpe (11) du contre-support (10) et pivote dans au moins une niche d'encliquetage (15) du contre-support (10),
- Fixation de l'objet (5) par rapport à la pince de robot (4) dans une disposition dans laquelle l'au moins une saillie (14) de la section de tête (13) du pied de maintien (6) s'engage derrière la découpe (11) du contre-support (10) et est pivotée dans l'au moins une niche d'encliquetage (15) du contre-support (10), en déplaçant la pince de robot (4) dans le sens opposé à l'enfoncement, de sorte qu'une précontrainte restante de l'organe de réglage (12) serre le pied de maintien (6) entre l'organe de réglage (12) et le contre-support (10).

12. Procédé selon la revendication 11, **caractérisé en ce que** dans la disposition dans laquelle la au moins une saillie (14) de la section de tête (13) du pied de maintien (6) s'engage derrière la découpe (11) du contre-support (10) et est pivotée dans la au moins une niche d'encliquetage (15) du contre-support (10), et en appuyant l'organe de réglage réglable (12) de la pince de robot (4) contre le pied de maintien (6) de l'objet (5), l'objet (5) est fixé par rapport à la pince de robot (4), l'organe de réglage (12) est automatiquement bloqué au moyen d'un dispositif de sécurité (20).

13. Procédé selon la revendication 11 ou 12, **caractérisé en ce que** l'amenée de la pince de robot (4) vers le pied de maintien (6) de l'objet (5) à prélever se fait par déplacement du bras de robot (2a) du robot (2), commandé automatiquement par le contrôleur de robot (2b), qui est adapté pour déplacer automatiquement les membres du bras de robot (2a) en réglant les articulations du bras de robot (2a) reliant les membres du bras de robot (2a), jusqu'à ce qu'une découpe (11) du contre-support (10) soit alignée avec le pied de maintien (6), en aidant une broche de centrage (21) fixée à la pince de robot (4) à s'approcher de l'objet (5) d'une manière qui touche la partie de tête (13) du pied de maintien (6) du récipient (5), dans un fonctionnement du bras de robot (2a) régulé en force/couple par la commande de robot (2b), jusqu'à ce que la partie découpée (11) du contre-support (10) soit alignée avec la partie de tête (13) du pied de maintien (6) de l'objet (5).

14. Procédé selon l'une quelconque des revendications 11 à 13, **caractérisé en ce que** le rapprochement de la pince de robot (4) du pied de maintien (6) de l'objet à prélever (5) est réalisé en déplaçant le bras de robot (2a) du robot (2), commandé de manière extra-automatique par le contrôleur de robot (2b) qui est adapté pour déplacer automatiquement les membres du bras de robot (2a) en réglant les articulations du bras de robot (2a) reliant les membres du bras de robot (2a), jusqu'à ce qu'une découpe (11) du contre-support (10) soit alignée avec le pied de maintien (6), est assisté par au moins un capteur (7) disposé sur la pince de robot (4), qui détecte au moins une grandeur de mesure d'une position relative de la pince de robot (4) par rapport à l'objet (5) et la transmet à la commande de robot (2b) pour la commande automatique du bras de robot (2a) au moyen de la commande de robot (2b) sur la base de la au moins une grandeur de mesure détectée.

15. Procédé selon l'une des revendications 11 à 14, **caractérisé en ce que** le procédé est mis en œuvre au moyen d'un robot (2) dont la bride d'outil (3) porte une pince de robot (4) selon l'une des revendications 1 à 13.
